Europäisches Patentamt

European Patent Office

Office européen des brevets

(19)

(11) Veröffentlichungsnummer : **0 066 281**
**B1**

(12) **EUROPÄISCHE PATENTSCHRIFT**

(45) Veröffentlichungstag der Patentschrift :
22.10.86

(51) Int. Cl.⁴ : **H 03 H  9/44**, H 03 H  9/145

(21) Anmeldenummer : **82104727.1**

(22) Anmeldetag : **28.05.82**

(54) **Pulskompressionsfilter nach Art einer dispersiven Verzögerungsleitung.**

(30) Priorität : 29.05.81 DE 3121516
18.03.82 DE 3209948

(43) Veröffentlichungstag der Anmeldung :
08.12.82 Patentblatt 82/49

(45) Bekanntmachung des Hinweises auf die Patenterteilung : 22.10.86 Patentblatt 86/43

(84) Benannte Vertragsstaaten :
**DE FR GB IT**

(56) Entgegenhaltungen :
GB-A- 1 492 766
PATENTS ABSTRACTS OF JAPAN, Band 5, Nr. 74 (E-
57)(746), 16. Mai 1981;
PATENTS ABSTRACTS OF JAPAN, Band 2, Nr. 55, 21.
April 1978; Seite 1304 E 78;

(73) Patentinhaber : **Siemens Aktiengesellschaft Berlin
und München
Wittelsbacherplatz 2
D-8000 München 2 (DE)**

(72) Erfinder : **Veith, Richard
Habichtstrasse 25
D-8025 Unterhaching (DE)**
Erfinder : **Stocker, Helmut, Dr.
Bahnwiesenstrasse 1
D-8011 Zorneding (DE)**
Erfinder : **Riha, Gerd, Dr.
Kamerunerstrasse 20
D-8000 München 82 (DE)**

**Beschreibung**

Die vorliegende Erfindung bezieht sich auf ein Pulskompressionsfilter, wie es im Oberbegriff des Patentanspruchs 1 angegeben ist.

Insbesondere in der Radar-Technik werden Pulskompressionsfilter verwendet, mit denen sich ein Impuls kurzer Zeitdauer in einen zeitlich langdauernden Impuls der Dauer T transformieren läßt. Dies erfolgt im allgemeinen auf der Sendeseite. Vorausgesetzt, daß auf der Empfangsseite ein angepaßtes Filter (matched filter) verwendet wird, läßt sich der auf der Sendeseite mit einem Pulskompressionsfilter zeitlich verlängerte Impuls in einen kurzen Impuls einer Zeitdauer größer/gleich 1/B rückumwandeln. Dieser rückumgewandelte Impuls ist zwangsläufig von zeitlichen Nebenmaxima mehr oder weniger geringerer Amplitudenhöhe begleitet, die von der vorgegebenen Filter-Übertragungsfunktion und dem Produkt aus der Dauer T des expandierten Impulses und der Bandbreite B des Filters (= T · B) abhängen.

Die Maßnahme der Impulsverbreiterung auf der Sendeseite wird insbesondere aus dem Grunde angewendet, einen Radar-Impuls mit hohem Energieinhalt bei begrenzter Sendeleistung aussenden zu können. Durch die auf der Empfangsseite wieder vorzunehmende Kompression kann angenähert dasjenige hohe zeitliche Auflösungsvermögen beibehalten werden, das bei einer Aussendung des ursprünglichen, kurzen Impulses erreicht werden würde. Dies höhere Impulsenergie ermöglicht eine größere Reichweite einer mit einer solchen Puls-Expansion/-Kompression ausgerüsteten Radar-Anlage.

Die theoretisch begründeten Vorteile der Puls-Expansion/-Kompression werden in der Praxis nicht vollständig erreicht, und zwar u. a. umsoweniger, je geringer der technische Aufwand für das Filter getrieben wird. Die zeitlichen Nebenmaxima treten aber nicht nur aufgrund des begrenzten Wertes des Produkts T · B der Pulskompressionsfilter auf, sondern sie erscheinen auch bei solchen in der Praxis verwendeten Filtern, die Toleranzen in der örtlichen Anordnung der Elektrodenfinger haben.

Derartige Filter haben ein piezoelektrisches Substrat, auf dessen Oberfläche die Elektrodenfinger in durch die Übertragungsfunktion vorgegebener Verteilung angeordnet sind. Diese Elektrodenfinger sind wechselweise an Zuführungselektroden (bus bars) angeschlossen.

Es gibt verschiedene Arten von Pulskompressionsfiltern. Ein solches ist eines nach Art einer angezapften phasencodierten Verzögerungsleitung. Es enthält Elektrodenfinger in einer solchen Anordnung, daß zu Gruppen zusammengefaßte Elektrodenfinger, die mit der einen oder mit der anderen Zuführungselektrode verbunden sind, aufeinanderfolgend unterschiedliche Phase haben, wobei die Aufeinanderfolge unterschiedlicher Phasen der Gruppen einer vorgegebenen Codierung folgt. Eine solche phasencodierte Leitung hat den Nachteil, daß relativ hohe Nebenmaxima im komprimierten Impuls auftreten, deren Mindesthöhe durch die Anzahl der Phasensprünge in dem übertragenen Impuls festgelegt ist. Außerdem hat eine solche Leitung auch den Nachteil, daß sie sehr empfindlich ist gegen Frequenzverschiebungen im Impulssignal und/oder in der Leitung, z. B. durch Dopplereffekt bzw. durch Temperatureffekt des Substrats.

Bei einem Pulskompressionsfilter nach Art einer dispersiven Verzögerungsleitung sind solche Nachteile vermieden. Eine solche Leitung hat aber andererseits wieder den Nachteil, daß (US-A-3 882 430) ihre einander benachbarten Elektrodenfinger fortlaufend unterschiedliche Abstände voneinander haben, z. B. von Elektrodenfinger zu Elektrodenfinger monoton sich vergrößernde oder sich verringernde Abstände, oder daß (GB-A-1 492 766, Fig. 1) die Elektrodenfinger auf mehrere solche Fingergruppen verteilt sind, die jede auf eine andere bestimmte Frequenz innerhalb des vorgegebenen Frequenzbandes abgestimmt ist. Diese Abstimmung besteht darin, daß entsprechend verschieden große $\lambda_f/4$-Fingerabstände und $\lambda_f/4$-Fingerbreiten der Elektrodenfinger der jeweiligen Fingergruppe vorliegt, d. h. die Elektrodenfinger haben von Gruppe zu Gruppe zwangsläufig nicht-einheitliche Breite und Abstände. Die Gruppenmitten-Abstände der einzelnen Gruppen sind dort als äquidistant erkennbar. Diese beiden Möglichkeiten bedingen technologische Herstellungsschwierigkeiten, weil ein solches Filter ohne weiteres eine Länge von 10 bis 15 cm haben kann. Die Werte für die Breitenabmessung und den Abstand der Elektrodenfinger voneinander gehen herab bis zu einer Größe von 1 μm. Für die Genauigkeit der Begrenzungen und der Abstände der Elektrodenfinger sind Toleranzen von bis zu weniger als 0,1 μm einzuhalten -nämlich um störende Nebenmaxima des wieder komprimierten Impulses zu vermeiden. Vorteilhaft ist es, solche Strukturen fotolithografisch mit verkleinernder Projektion einer Vorlage auf dem Substrat herzustellen. In der Praxis stehen jedoch nur solche ausreichend verzerrungsfreien Projektionseinrichtungen zur Verfügung, deren Bildfelddurchmesser nur einen Bruchteil der Länge der Fingerstruktur beträgt. Man ist daher gezwungen, die ganze Elektrodenfinger-Struktur mit sich änderndem Elektrodenfinger-Abstand und sich ändernder Elektrodenfinger-Breite aus mehreren Abschnitten zusammengesetzt herzustellen.

Es hat sich gezeigt, daß durchaus Support-Vorschübe für Projektionseinrichtungen zur Verfügung stehen, die relativen Vorschub von Substrat und Vorlage mit hoher Genauigkeit realisieren lassen. Muß man jedoch die Vorlage wechseln — wie dies bei sich ständig änderndem Elektrodenfinger-Abstand und Breitenmaß notwendigerweise der Fall ist — ergeben sich nicht tragbare Ungenauigkeiten in der Elektrodenfinger-Struktur. Ein Ausweg aus der voranstehend aufgezeigten Schwierigkeit ist, daß man einen jeden einzelnen Elektrodenfinger des Filters bzw. der Leitung oder die Elektrodenfinger jeder Gruppe für sich genommen durch individuelle Belichtung, d. h. durch eine Einzelmaßnahme, herstellt.

2

Der zeitliche Aufwand zur Durchführung eines solchen Verfahrens ist für die Herstellung eines Pulskompressionsfilters mit einer solchen Elektrodenfinger-Struktur nicht wirtschaftlich.

Lediglich der Vollständigkeit halber sei auf Verfahren der Vervielfältigung mit Kontaktabzug einer Maske hingewiesen, die aber wegen damit verbundener Verunreinigung der Substratoberfläche weniger vorteilhaft ist.

Es ist eine Aufgabe der vorliegenden Erfindung, eine solche Maßnahme zu finden, mit der die bisher in Kauf genommenen technologischen Herstellungsschwierigkeiten für ein solches Pulskompressionsfilter vermieden werden, das wie Filter nach Art dispersiver Verzögerungsleitungen hohe Dämpfung der Nebenmaxima und/oder geringe Empfindlichkeit gegen Frequenzabweichung (Doppelereffekt, Temperatureffekte) hat.

Diese Aufgabe wird für ein Pulskompressionsfilter mit den Merkmalen des Anspruchs 1 gelöst.

Der vorliegenden Erfindung liegt die Überlegung zugrunde, die technologischen Schwierigkeiten der Herstellung eines Pulskompressionsfilters nach Art einer dispersiven Verzögerungsleitung dadurch zu beseitigen bzw. entscheidend zu mindern, daß man eine derart ausgebildete Elektrodenfinger-Struktur findet, mit der die Struktur mit Elektrodenfingern mit nichtäquidistanten Abständen und nicht-gleichen Elektrodenfinger-Breiten ersetzt werden kann und die sich entsprechend leichter herstellen läßt. Selbstverständlich darf diese ersatzweise anzuwendende Elektrodenfinger-Struktur nicht zu unzulässigen technischen Nachteilen führen, d. h. die Übertragungseigenschaften des erfindungsgemäßen Filters müssen die generell und/oder im Einzelfall geforderten Bedingungen in noch genügendem Maße erfüllen. Zum Beispiel genügt es im Regelfall, daß Nebenmaxima in dem (auf der Empfangsseite) wieder komprimierten Impuls lediglich wenigstens um 30 dB kleiner als die Amplitude des Hauptmaximums des wiedergegebenen Impulses sind.

Es ist hier vorgesehen, anstelle einer Gesamtheit von Elektrodenfingern mit ständig zunehmenden bzw. sich von Gruppe zu Gruppe ändernden Elektrodenfinger-Breiten und -Abständen voneinander aus jeweils einer begrenzten Anzahl von Elektrodenfingern bestehende Gruppen zu verwenden. Es wird eine Anzahl N Fingergruppen verwendet, die in sich bzw. untereinander bezüglich der Anzahl $n$ der sie bildenden Elektrodenfinger und bezüglich der Abstände der $n$ Elektrodenfinger in der einzelnen Fingergruppe identisch ausgebildet sind. In diesem Zusammenhang sei auch erwähnt, daß innerhalb der Fingergruppen der Abstand zwischen benachbarten Elektrodenfingern nicht äquidistant zu sein braucht ; diese Aufteilung dann aber für alle N Fingergruppen identisch gilt.

Für diese Fingergruppen genügt somit die Herstellung einer einzigen, vorzugsweise vergrößerten Vorlage, die im lithografischen Verfahren (verkleinert) auf die fotolithografische Schicht des Filtersubstrats projiziert wird. Die geforderte Übertragungsfunktion wird dadurch berücksichtigt, daß man den jeweiligen Abstand von der Mitte der einen Fingergruppe zur Mitte der benachbarten Fingergruppe (Mittenabstände) fortlaufend größer (oder kleiner) bemißt.

Der entscheidende Vorteil eines solchen Filters mit ersatzweisen Fingergruppen liegt darin, daß eine jede einzelne Fingergruppe mit ein und derselben, in die Projektionsvorrichtung eingelegten Vorlage zur Belichtung im fotolithografischen Prozeß verwendet werden kann. Eine Fingergruppe wird zeitlich nach der anderen Fingergruppe projiziert, und zwar nachdem die notwendige laterale Verschiebung (in Richtung oder Gegenrichtung der späteren Fortpflanzungsrichtung der Welle im fertigen Filter) mit dem durch die vorgegebene Übertragungsfunktion vorgeschriebenen Maß des jeweiligen Abstandes zwischen benachbarten Fingergruppen vorgenommen worden ist. Eine bis auf eine Genauigkeit von zehntel Mikrometer exakte laterale Verschiebung von Vorlage und Filtersubstrat gegeneinander ist relativ unproblematisch. Bei der Erfindung ist jedoch das gegenüber dem Stand der Technik notwendige Auswechseln der Vorlage vermieden, was zwangsläufig zu erhöhten Ungenauigkeiten bei der Herstellung der Fingerstruktur führen würde.

Bezüglich der Erfindung sei darauf hingewiesen, daß die vorgesehenen Fingergruppen, die in Ausbreitungsrichtung der Welle im Filter eine Länge 1 wenigstens angenähert gleich der mittleren Weglänge $\lambda_0$ haben, nicht mit solchen Anordnungen verwechselt bzw. gleichgesetzt werden dürfen, die sogenannte « split fingers » haben. Solche split finger-Anordnungen ersetzen bzw. repräsentieren nämlich in sich einen einzigen Elektrodenfinger. Solche split finger-Anordnungen haben daher auch eine Länge (gemessen über die gesamte Länge der split finger-Anordnung in Fortpflanzungsrichtung), die das Maß $\lambda_0/2$ nicht (wesentlich) übersteigt. Bei der Erfindung beträgt die Länge der Fingergruppe schon bei geringer Anzahl der in ihr enthaltenen Finger ein Vielfaches von $\lambda_0/2$. Ist innerhalb einer bei der Erfindung vorgesehenen einzelnen Fingergruppe sogar eine verdünnte Anordnung von Elektrodenfingern vorgesehen, d. h. ist der Abstand von einem Elektrodenfinger zum benachbarten Elektrodenfinger ein Vielfaches von $\lambda_0/2$, so haben im Sinne der Erfindung vorgesehene Fingergruppen eine Länge 1 (in Ausbreitungsrichtung der Welle), die eine Anordnung sogenannter split fingers mit gleicher Fingeranzahl weit überschreitet. Zu « split fingers » ist im übrigen noch zu bemerken, daß die benachbarten Fingerstreifen des einzelnen, jeweiligen aufgespalteten Fingers alle elektrisch miteinander verbunden sind. Zur Erfindung ist aber noch zu erwähnen, daß die $n$ einzelnen Elektrodenfinger in den N Fingergruppen des erfindungsgemäß ausgebildeten Pulskompressionsfilters für sich zusätzlich als split fingers ausgebildet sein können, wobei (wie oben schon angegeben) die Gesamtheit der Fingerstreifen, die jeweils den einzelnen der $n$ Elektrodenfinger ersetzen, nicht breiter als $\lambda_0/2$ ist.

Weitere Erläuterungen der Erfindung gehen aus der nachfolgenden Figurenbeschreibung hervor.

Figur 1  zeigt ein der Erfindung entsprechendes Pulskompressionsfilter mit Fingergruppen mit voneinander nichtäquidistanten Abständen.

Figur 2  zeigt das für die vorliegende Erfindung relevante bekannte Pulskompressionsfilter nach Art einer despersiven Verzögerungsleitung.

Figur 3  zeigt eine an sich bekannte Vorrichtung zur Herstellung eines Pulskompressionsfilters nach der vorliegenden Erfindung.

Figur 4  zeigt eine bildliche Erläuterung zu dem Begriff « split fingers ».

Figur 5  zeigt in Detaildarstellung eine Fingergruppe mit gewichteten Fingern und

Figur 6  zeigt drei Fingergruppen eines Pulskompressionsfilters nach der Erfindung mit gruppenweise variierter Fingerwichtung.

Figur 7  zeigt einen « reflective array compressor » mit erfindungsgemäß ausgebildetem Reflektor.

Figur 8  zeigt eine Anordnung einer Weiterbildung.

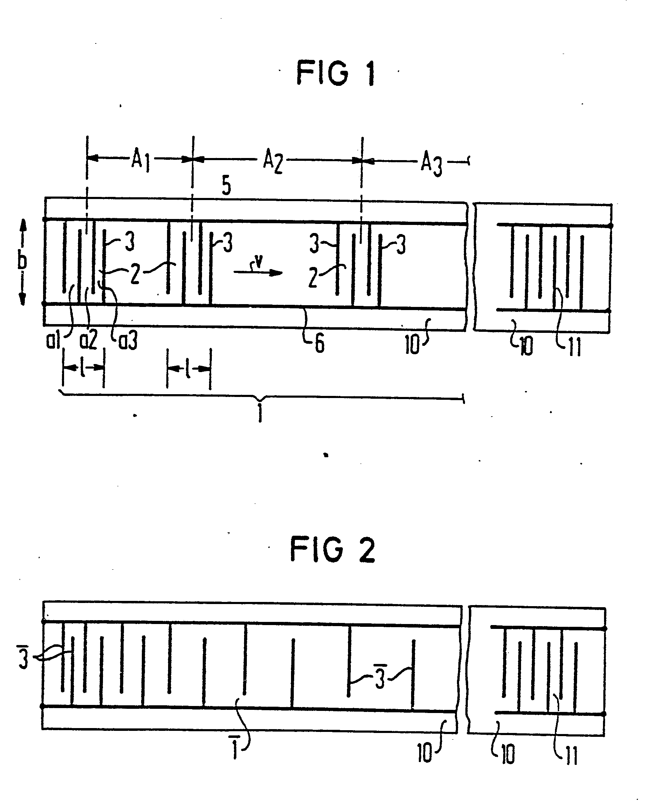

Fig. 1 zeigt eine prinzipielle Darstellung eines Pulskompressionsfilters mit einem Eingangswandler 1 auf einem Substrat 10. Mit 11 ist ein Ausgangswandler bezeichnet. Als Abschnitt des Eingangswandlers 1 sind in der Fig. 1 $N = 3$ Fingergruppen 2 wiedergegeben, die jeweils aus $n = 4$ einzelnen Fingern 3 bestehen, die Abstände $a_1$, $a_2$, $a_3$ haben. Es kann gelten $a_1 \neq a_2 \neq a_3$. Die Mittenabstände $A_1$, $A_2$ und $A_3$ der jeweils einander benachbarten Fingergruppen 2 sind entsprechend dem Erfindungsgedanken unterschiedlich groß. Sie ergeben sich aus der für das betreffende Pulskompressionsfilter vorgegebenen Übertragungsfunktion. Die einzelnen Fingergruppen 2 sind bezüglich der Anzahl n der Elektrodenfinger 3, der Abstände $a_1$, $a_2$, $a_3$ ... und der zur Ausbreitungsrichtung v orthogonalen geometrischen Fingerlänge 1 identisch bemessen. Es sei schon hier darauf hingewiesen, daß für die Elektrodenfinger 3 einer (jeden) Fingergruppe 2 auch unterschiedliche aktive Fingerlänge vorgesehen sein kann, nämlich entsprechend einer Wichtung der Finger. Dieser Wandler 1 kann der Eingangs- oder der Ausgangswandler sein. Es können aber auch Eingangswandler und Ausgangswandler entsprechend dem Wandler 1 ausgebildet sein.

Fig. 2 zeigt das Prinzip eines an sich bekannten Pulskompressionsfilters nach Art einer dispersiven Verzögerungsleitung, dessen Wandler 1 aus einer Vielzahl von Elektrodenfingern $\bar{3}$ besteht, wobei (in der Fig. 2) der Abstand der einzelnen Elektrodenfinger $\bar{3}$ in Richtung v monoton zunehmend ist. Dieser bekanntermaßen vorliegende Abstandszuwachs bzw. die Aufteilung der Elektrodenfinger $\bar{3}$ über die Gesamtlänge des in Fig. 2 dargestellten bekannten Pulskompressionsfilters ergibt sich wiederum aus der vorgegebenen Übertragungsfunktion.

Für das Beispiel der Fig. 1 dieses erfindungsgemäßen Filters ist monotones Anwachsen der Abstände $A_1$, $A_2$, $A_3$ ... vorgesehen, und es genügt bei Einhaltung der anspruchsgemäßen Beding $N > T - B$, daß sich die Abstandswerte $A_i$ in weniger feiner Abstufung vergrößern, als dies beim Beispiel der Fig. 2 des bekannten Filters der Fall ist.

Der bevorzugte jeweilige Mittenabstand $a_i$ zweier benachbarter Elektrodenfinger 3 innerhalb einer Fingergruppe 2 beträgt in der Regel $\lambda_0/2$, wobei man die Streifenbreite eines einzelnen Elektrodenfingers 3 mit $\lambda_0/4$ bemißt. $\lambda_0$ ist die Wellenlänge der akustischen Welle in dem Substrat, und zwar für den mittleren Frequenzwert $f_0$ des Frequenzbandes der Übertragungsfunktion. Bei diesem Beispiel hat somit eine Fingergruppe 2 in Ausbreitungsrichtung v der Welle eine Länge 1, das ist angenähert der Mittenabstand zwischen den beiden äußersten Elektrodenfingern 3 einer Fingergruppe 2, von $1 = 3 \lambda_0/2$. In der praktischen Realisierung eines erfindungsgemäßen Pulskompressionsfilters enthält z. B. eine Fingergruppe 2 eine Anzahl $n = 4$ bis 20 Elektrodenfinger 3, und das ganze Filter besteht aus z. B. $N = 10$ bis 1 000 Fingergruppen 2. Die Gesamtlänge von der ersten Fingergruppe 2 bis einschließlich der letzten Fingergruppe 2 eines erfindungsgemäßen Filters nach Fig. 1 ist im Regelfall gleich groß der Gesamtlänge eines vergleichbaren bekannten Filters nach Fig. 2.

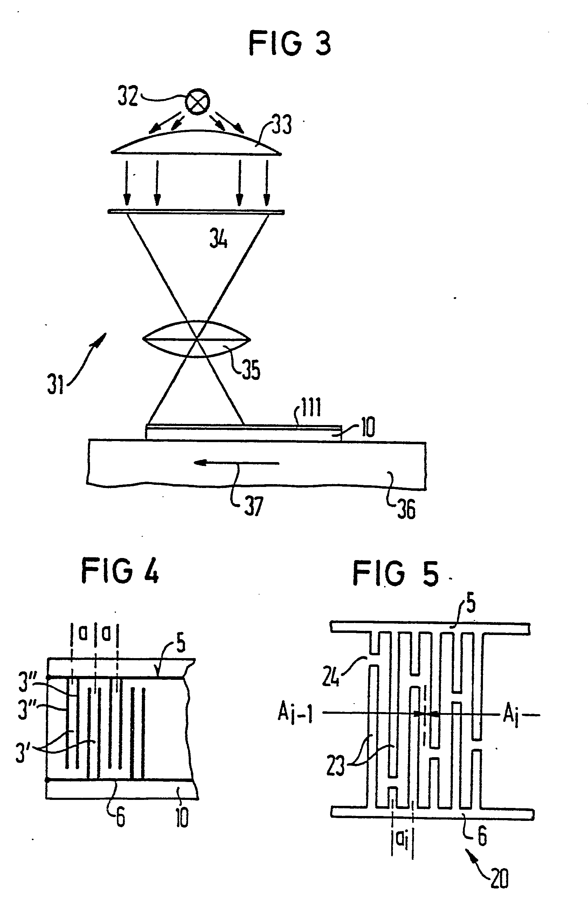

Im Herstellungsverfahren eines Filters nach Fig. 1 wird eine einzige Vorlage für die vier Elektrodenfinger 3 einer Fingergruppe 2 in der Projektionseinrichtung verwendet. Fig. 3 zeigt eine solche Projektionseinrichtung 30 mit einer Lichtquelle 32, einem Kondensor 33, der Vorlage 34, dem abbildenden Objektiv 35 und dem Substrat 10 des Filters 1, auf dessen Oberfläche das Bild der Vorlage 34 verkleinert wiedergegeben wird. Diese Oberfläche des Substrats 10 ist mit einer fotoempfindlichen Schicht 11 bedeckt. Weitere Einzelheiten für das fotolithografische Verfahren sind bekannt und brauchen hier daher nicht mehr erläutert zu werden.

Das Substrat 10 befindet sich in der Vorrichtung 31 auf einem Support 36, der (gegenüber der Vorlage 34) in Richtung 37 mit feinster Justierung verschoben werden kann. Es kann somit die eine Fingergruppe der Vorlage 34 auf einem mit größtmöglicher Genauigkeit vorgegebenen Ort der auf dem Substrat 10 befindlichen Foto-Emulsionsschicht 111 projiziert werden, d. h. die Schicht 36 wird von Fingergruppe zu Fingergruppe 2 um die Abstände $A_i$ weitergeschoben.

Aus der Fig. 1 geht auch die Art und Weise hervor, wie die einzelnen Elektrodenfinger 3 mit den beiden Schienen 5 und 6 (bus bars) elektrisch verbunden sind. Fig. 4 zeigt dazu eine einzelne Fingergruppe 2', in der die Elektrodenfinger 3' als « split finger »-Ausführung realisiert sind. Ein jeder « split finger »-Elektrodenfinger 3' besteht — wie dargestellt — aus zwei benachbarten, miteinander verbundenen Fingerstreifen 3'' und 3''', die elektrisch parallelgeschaltet sind. Die jeweils beiden Fingerstreifen 3'' und 3''' sowie der zwischen ihnen befindliche Zwischenraum haben eine Gesamtbreite 3 $\lambda_0/8$, nämlich etwa gleich groß einem Finger 3 (oder auch $\bar{3}$). Die Darstellung der Fig. 4 enthält vier in je

4

zwei Fingerstreifen 3", 3''' aufgespaltene Elektrodenfinger 3'.

Fig. 5 zeigt als Erläuterungsbeispiel die Ausführungsform einer einzelnen Fingergruppe 20 mit gewichteten Fingern 23, wie sie für sich genommen an sich hinlänglich bekannt sind. Diese Fingerwichtung dient der Realisierung des vorgegebenen Amplitudenverlaufs der vorliegenden Übertragungsfunktion. Im Regelfall ist die Wichtung der Elektrodenfinger 23 für die einzelnen Fingergruppen 20 des ganzen Pulskompressionsfilters durchaus verschieden, d. h. insoweit liegt dann keine Identität mehr für alle N Fingergruppen untereinander vor. Dies ist aber kein Mangel oder Nachteil der Erfindung. Auch eine Ausführungsform mit Fingergruppen 20 mit gewichteten Fingern 23 wird mit einer Vorrichtung nach Fig. 3 nach dem oben beschriebenen Prinzip der Erfindung hergestellt. Die Finger 23 werden zunächst als von einem « bus bar » zum andern « bus bar » durchgehende Elektrodenstreifen hergestellt, die erst später durch einen zweiten Belichtungsvorgang an den Trennstellen unterbrochen werden. Mit 24 ist auf eine solche Trennstelle hingewiesen.

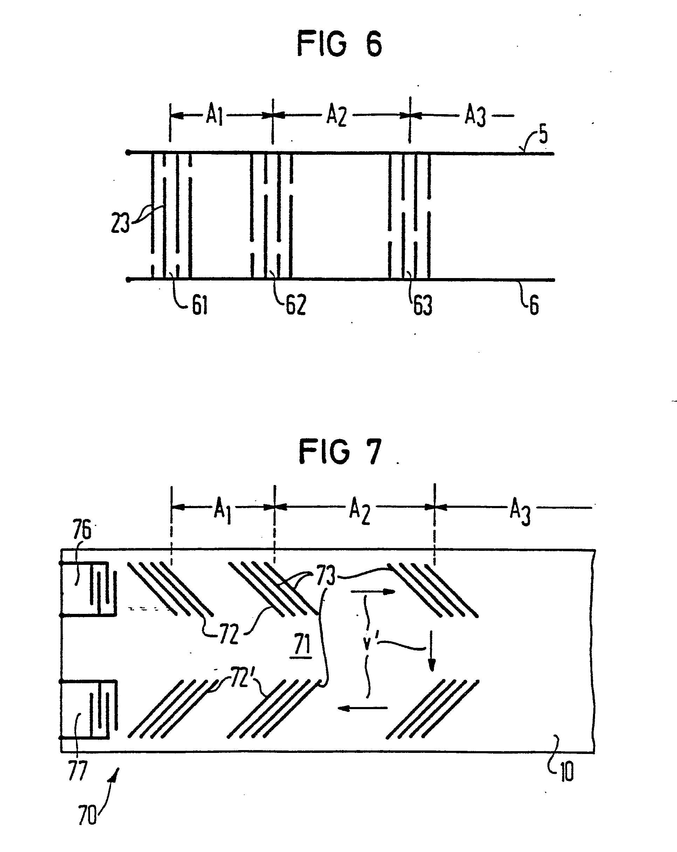

Einer bevorzugten Weiterbildung der Erfindung entsprechend ist vorgesehen — wie Fig. 6 für drei Fingergruppen 61, 62 und 63 zeigt — die bekannte Fingerwichtung eines bekannten Filters nach Fig. 2 ersatzweise vereinfacht so zu realisieren, daß innerhalb einer einzelnen Fingergruppe 61, 62, 63 die Fingerwichtung aller Elektrodenfinger 23 gleich ist, diese Fingerwichtung jedoch stufenweise von Fingergruppe zu Fingergruppe (der vorgegebenen Übertragungsfunktion entsprechend angenähert) variiert ist.

Die Erfindung läßt sich auch für das Reflektorgitter eines Pulskompressionsfilters verwenden, das dem Fachmann als « reflective array compressor » bekannt ist. Wie die Fig. 7 zeigt, hat ein solches Filter 70 Eingangs- und Ausgangswandler 76, 77. Es sind dies Wandler allgemeiner Art mit interdigitalen Elektrodenfingern. Die Wandler befinden sich auf einem Substrat 10, das im Bereich dieser Wandler piezoelektrisch sein muß. Im übrigen Bereich, nämlich im Bereich des Reflektorgitters 71, braucht dieses Substrat 10 nicht piezoelektrisch zu sein.

Bekannte « reflective array compressors » sind bisher in der Weise realisiert worden, daß die zueinander schräggestellten Reflektorfinger untereinander monoton zunehmenden (oder abnehmenden) Abstand voneinander haben, wie dies in Fig. 2 für die Elektrodenfinger des Wandlers $\bar{1}$ gezeigt ist.

Fig. 7 zeigt eine der Erfindung gemäße Anordnung 71 der Reflektorfinger 73. Diese Reflektorfinger 73 sind aufgeteilt auf N Fingergruppen 72 und auf N Fingergruppen 72'. Es gehören jeweils eine Fingergruppe 72 und eine ihr gegenüberliegende Fingergruppe 72' als eine Einheit zusammen, so daß N solcher Einheiten im Sinne der Erfindung vorzusehen sind. Eine jede Fingergruppe 72, 72' besteht aus n Reflektorfingern 73. Die Fingergruppen 72 und die Fingergruppen 72' sind untereinander identisch. Ihre für die Reflektion notwendige Schrägstellung entspricht dem Stand der Technik. Mit v' ist für eine Einheit der Fingergruppen 72, 72' der Weg der akustischen Welle angedeutet, wofür hier der Wandler 76 als Eingangswandler angenommen ist.

Bei dem Filter 70 können die Reflektorfinger Metallstreifen sein (jedoch ohne bus bar), wie sie als Elektrodenfinger zum obengenannten Filter beschrieben sind. Für ihre Funktion als Reflektoren ist aber elektrische Leitfähigkeit derselben nicht notwendig. Die Reflektorfinger 73 können auch streifenförmige Gruben sein, die in die Oberfläche des Substrats 10 eingebracht (z. B. eingeätzt) sind.

Für das Filter 70 gelten im übrigen die oben zu den Figuren 1 und 3 gegebenen Hinweise. Eine Fingerwichtung kann auch bei einem Filter 70 vorgesehen sein, die — wie bekannt — in der Weise realisiert sein kann, daß einzelne Finger 73 unterschiedliche Tiefe im Substrat 10 haben und/oder in einzelne, in Reihe angeordnete, punktförmige Vertiefungen mehr oder weniger großer linearer Dichte aufgelöst sind.

Es ist oben bereits darauf hingewiesen worden, daß die Abstände $a_i$ der Elektrodenfinger auch nichtäquidistant sein können. Dies gilt im übrigen auch für gewichtete Elektrodenfinger 23 und für « split finger »-Anordnungen 3'. Zum Beispiel kann ein nichtäquidistanter Abstand einer Fingergruppe 2, 61 ... darauf beruhen, daß Fingerpaare weggelassen sind, die Fingergruppe bezüglich der Fingerelektroden somit verdünnt ist. Wie ebenfalls bereits oben angedeutet, liegt (abgesehen vom Fall einer « split finger »-Anordnung) der Fall maximaler Elektrodenfinger-(Reflektorfinger-)Dichte dann vor, wenn die Mittenabstände benachbarter Finger 3, 23, 3', 73 $a_i = \lambda_o/2$ beträgt, wobei $\lambda_o$ die Wellenlänge der akustischen Welle in dem Filter für die Mittenfrequenz $f_o$ des Filters ist und wobei im Falle von Elektrodenfingern benachbarte Elektrodenfinger an jeweils verschiedene bus bars 5 und 6 angeschlossen sind (und ein Fingerpaar sind).

Von besonderm Vorteil ist es auch, in einer (jeden) Fingergruppe 2, 61 ... in gleicher Folge Fingerpaare 3, 23, 73 wegzulassen, d. h. die Fingergruppe zu verdünnen. Eine solche Fingergruppe hat dann insbesondere äquidistante Abstände $a_i$, die gleich einem Vielfachen, insbesondere ungeradzahligem Vielfachen von $\lambda_o/2$ sind. Auch in solch einer verdünnten Fingergruppe sind einander benachbarte Finger 3, 23 (bei Funktion als Elektrodenfinger) an jeweils verschiedene bus bars 5 und 6 angeschlossen, jedoch mit $a_1 = a_2 = a_3$). Für die Gesamtlänge 1 einer solchen Fingergruppe gilt dann, daß sie ein Mehrfaches von $n \cdot \lambda_o/2$ beträgt. Wenn aus einer Anordnung mit maximaler (d. h. $a_i = \lambda_o/2$) Fingerdichte z. B. je ein solches Fingerpaar weggelassen ist (das aus benachbarten, an verschiedene bus bars 5, 6 angeschlossenen Elektrodenfingern besteht), betragen die Abstände $a_i$ der dann verbleibenden einander benachbarten (an jeweils verschiedene bus bars 5, 6 angeschlossenen Elektrodenfinger $a_i = 3 \cdot \lambda_o/2$, und für die ganze Fingergruppe 2 gilt dann $1 = 3 \cdot n \cdot \lambda_o/2$. Auch für solche Ausführungsformen werden Abmessungen für die Breite der Elektroden- bzw. Reflektorfinger bevorzugt, die etwa $\lambda_o/4$ betragen.

Es sind bereits zuvor Hinweise auf eine Wichtung der Elektroden- bzw. Reflektorfinger eines voranstehend beschriebenen erfindungsgemäßen Pulskompressionsfilters gegeben worden. Von ganz besonderem Vorteil ist es jedoch, diese Wichtung in der Weise zu realisieren, daß gruppenweise die zu einer solchen Gruppe gehörenden Finger entsprechend einer noch nachfolgend angegebenen Bemessung zusätzlich in Richtung bzw. in Gegenrichtung der Hauptrichtung z der Wellenausbreitung v um ein jeweiliges Maß $\Delta z_i$ verschoben werden.

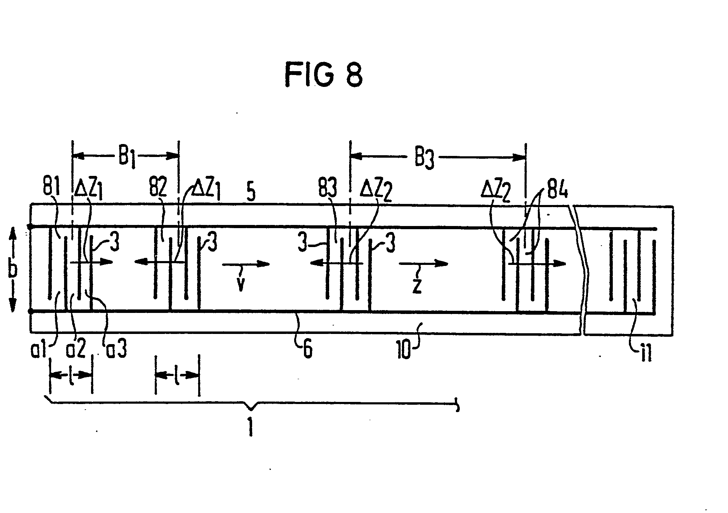

Weitere Erläuterungen der Weiterbildung werden anhand der Fig. 8 beschrieben. Viele Einzelheiten dieser Fig. 8 stimmen mit denjenigen der Fig. 1 überein. Mit der Fig. 1 übereinstimmende Bezugszeichen haben in der Fig. 8 prinzipiell die gleiche Bedeutung.

Die mit 81 bezeichnete Fingergruppe wird im Zusammenhang mit dieser Weiterbildung im folgenden als Subgruppe bezeichnet. Entsprechendes gilt für die weiteren Subgruppen 82, 83, 84.

Die Mittenabstände $B_1$, $B_3$ ... sind bei einer gemäß der Weiterbildung entsprechend Fig. 8 gewichteten Ausführungsform um ein dieser Weiterbildung entsprechendes jeweiliges Maß $\Delta z_i$ verschieden gegenüber den zu Fig. 1 angegebenen Abständen $A_1$, $A_3$ ... ... Für die der Weiterbildung entsprechende Bemessung ist es erforderlich, Hauptgruppen zu bilden, die jeweils mindestens zwei benachbarte Subgruppen umfassen ; z. B. umfaßt eine Hauptgruppe die Subgruppen 81 und 82, und die nächstfolgende Hauptgruppe die Subgruppen 83 und 84. Dieses entspricht der feinsten Aufteilung. Es können nämlich auch drei oder noch mehr benachbarte Subgruppen eine Hauptgruppe bilden.

In der Fig. 8 ist für die erste Subgruppe 81 mit $\Delta z_1$ eine mögliche, der geforderten Wichtung gemäß der Weiterbildung bemessene (Wichtungs-) Verschiebung der Finger 3 dieser Subgruppe 81 angedeutet. Die definitionsgemäß zur selben Hauptgruppe gehörende Subgruppe 82 hat eine Verschiebung der Finger um $\Delta z_1$ in Gegenrichtung, so daß in der Summe für diese Hauptgruppe sich der Wert Null ergibt. Wie auch aus der Fig. 8 ersichtlich, sind entsprechende Verschiebungen $\Delta z_2$ für die zur nächsten. Hauptgruppe gehörenden Subgruppen 83 und 84 angegeben. Je nach Bemessung kann diese Verschiebung $\Delta z_2$ für diese beiden Subgruppen 82 und 84 aufeinander zu oder — wie dargestellt — voneinander weg gerichtet sein.

Eine solche Wichtung ist für ein Pulskompressionsfilter der voranstehend beschriebenen Erfindung besonders einfach durchführbar, da die Wichtungsverschiebung $\Delta z$ der Finger, genau genommen der Fingerkanten, für eine jeweilige Subgruppe einheitlich ist. Es kann also weiterhin auch ein Pulskompressionsfilter nach der Weiterbildung so hergestellt werden, daß die einzelnen einander identischen Finger (Sub-)Gruppen in jeweils einem Stück (durch Projektion oder im Kontaktverfahren) belichtet werden. In Fig. 8 ist gegenüber dem in Fig. 1 dargestellten Filter lediglich die jeweilige Wichtungsverschiebung $\Delta z$ zusätzlich zu überlagern, so daß sich bei diesen Beispiel die Werte $A_1$, $A_3$ vom den Werten $B_1$ und $B_3$ um $2\Delta z_{1,2}$ unterscheiden. Entsprechendes gilt bei Hauptgruppen mit mehr als zwei Subgruppen.

Die für diese Weiterbildung jeweils zu treffende Bemessung von $\Delta z_i$ geht aus den nachfolgenden Ausführungen hervor. Die nachfolgend wiedergegebene Gleichung

$$s(t) = a(t) \cdot e^{j[\omega_0 t + \varphi(t)]} \tag{I}$$

ist die für das Pulskompressionsfilter vorgegebene Impulsantwort.

Für die Bemessung der Werte $\Delta z$ der Weiterbildung wird dieser Ausdruck in die folgende Form umgewandelt, in der sich die Funktion s(t) aus der Faltung mit der Funktion $\tilde{s}(t)$ ergibt :

$$s(t) = r(t) \cdot e^{j[\omega_0 t + \varphi(t) + b(t)]} * g(t) = \tilde{s}(t) * g(t) . \tag{II}$$

In dieser Darstellung ist die Amplitudenfunktion a(t) in die Phasenfunktion b(t) übergeführt worden, die entsprechend entscheidend für die erfindungsgemäße Bemessung der Verschiebung der Finger der jeweiligen Subgruppe 81, 82, 83, 84 zur Wichtung des Filters ist. Diese hier zu realisierende Wichtung a(t) ergibt sich aus der für das betreffende Filter vorgegebenen Übertragungsfunktion nach Betrag und Gruppenlaufzeit desselben.

Mit dieser mathematischen Transformation von s(t) in $\tilde{s}(t)$ geht das Auftreten des Ausdrucks r(t) und der weiteren Faltungsfunktion g(t) einher. Die Funktion r(t) ist die Einhüllende der nicht mit der erfindungsgemäßen zusätzlichen Phasenwichtung ausgestatteten Digitalstruktur. Die Faltungsfunktion g(t) stellt im wesentlichen die Filter-Impulsantwort von Eingangswandler und Ausgangswandler (bei einer Interdigitalstruktur bzw. einer « in-line »-Reflektorstruktur) dar oder sie entspricht der der Apertur einer Reflektorstruktur mit schräggestellten Reflektorfingern, d. h. mit zweimaliger 90°-Reflexion, eigenen faltungsähnlichen Integration (Filterung). Diese Funktion g(t) wird mit der erfindungsgemäß modifizierten Funktion $\tilde{s}(t)$ Gleichung (II) gefaltet. Dieser mathematisch als Faltung bezeichnete Vorgang entspricht im Frequenzbereich einer Ausfilterung von Seitenbändern.

Die erwähnten Seitenbänder werden im Zusammenhang mit der Erfindung weggefiltert, und zwar in erster Linie durch entsprechende Bandbreite des Eingangswandlers und/oder des Ausgangswandlers. Wie ebenfalls schon mit anderen Worten gesagt, kann dies für die Reflektorstruktur mit schräggestellten Fingern durch Wahl eines entsprechend großen Aperturwertes, d. h. entsprechend langen Fingern der Struktur, erzielt werden. Lediglich der Vollständigkeit halber sei darauf hingewiesen, daß diese Filterung aber auch außerhalb des eigentlichen erfindungsgemäßen Filters erfolgen kann, z. B. in weiteren filternd wirkenden Baugruppen eines ganzen Gerätes. Wegen der sich bei einem derartigen Oberflächenwellenfilter bietenden sehr einfachen Möglichkeit der Ausfilterung solcher Seitenbänder, wird aber von der letztgenannten Möglichkeit selten Gebrauch gemacht werden.

Zur Realisierung der modifizierten Funktion š(t) (entsprechend Gleichung II) sind in der ganzen gewichteten Digitalstruktur die Finger oszillierend (mit einer Mindestfrequenz) verschoben, und zwar gegenüber einer örtlichen Lage (in der Struktur), die sich für eine entsprechende Digitalstruktur ergeben würde, wenn diese am betreffenden Ort der jeweiligen Finger keine Wichtung hätte, d. h. die Finger dort ungewichtet wären.

Die erfindungsgemäß vorgesehene Verschiebung $\Delta z_i$ der Finger der i-ten Subgruppe erfolgt entsprechend der (noch weiter zu erörternden) Funktion b(t). Es wird die jeweilige Anzahl der Finger der einzelnen Subgruppen zusammengefaßt, d. h. für alle Finger einer jeweiligen Subgruppe gilt jeweils dasselbe Maß der Verschiebung nach Betrag ($\Delta z_i$) und Richtung. In einem gewichteten Bereich der erfindungsgemäßen Filterstruktur ist eine Vielzahl von Subgruppen vorhanden. Eine jede Subgruppe hat mindestens zwei reale Finger. Bevorzugt wird sie eine größere Anzahl Finger umfassen. Diese weiteren Finger können reale und virtuelle Finger sein. Ein realer Finger ist ein solcher, der tatsächlich in der Struktur z. B. als Metallisierungsstreifen vorhanden ist. Ein virtueller Finger ist im Sinne der Weiterbildung ein Finger oder Digitstreifen, der in der Struktur weggelassen ist.

Bei der Weiterbildung wird eine Anzahl Subgruppen zur erfindungsgemäßen Bemessung der Finger-Verschiebung $\Delta z_i$ zu je einer Hauptgruppe zusammengefaßt. Eine jede Hauptgruppe enthält mindestens zwei reale, d. h. tatsächlich in der Struktur durch Finger repräsentierte Subgruppen. Für diese beiden Subgruppen einer jeweiligen Hauptgruppe gilt die Vorschrift, daß die· Finger der einen Subgruppe entgegengesetzt (aufeinander zu oder voneinander weg) zu den Fingern der anderen Subgruppe verschoben werden. Für eine Hauptgruppe mit mehr als zwei Subgruppen liegen mehrere Möglichkeiten vor, so z. B. bei drei Subgruppen, daß die mittlere Subgruppe unverschoben bleibt und nur die Finger der einen äußeren Subgruppe zu denen der anderen verschoben werden. Bei einer Hauptgruppe aus vier Subgruppen können z. B. eine oder zwei Subgruppen unverschoben bleiben. Die Beträge der Verschiebungen der realen Subgruppen einer Hauptgruppe (mit mehr als zwei realen Subgruppen) müssen nicht gleich sein. Es muß jedoch die Summe der Verschiebungen aller Subgruppen einer solchen Hauptgruppe gleich Null sein, abgesehen davon, daß hier die unterschiedlichen Fingerabstände aufgrund der vorgegebenen Dispersion bzw. nicht-konstanten Gruppenlaufzeit das Maß dieser Finger-Abstandsunterschiede (als sehr geringe Korrekturgröße) eingehen und/oder abgesehen davon, daß Finger einer jeweiligen Subgruppe unterschiedlichen elektromechanischen (Interdigitalwandler) bzw. mechanischen (Reflektor) Wirkungsgrad haben und/oder daß ihre Anzahl verschieden ist.

Zur Realisierung der Weiterbildung gilt auch eine Vorschrift für eine Mindestanzahl n von Hauptgruppen, und zwar es gilt, n muß wenigstens gleich oder größer als das Zeit-Bandbreite-Produkt (T · B) sein, worin T die Dauer der Filter-Impulsantwort und B die Bandbreite der vorgegebenen Übertragungsfunktion ist.

Bereits oben wurde erwähnt, daß noch weitere Angaben zur Funktion der zusätzlichen Phasenmodulation b(t) zu machen sind. Es gilt die Beziehung

$$\overline{e^{jb(t)}} \approx \frac{a(t)}{r(t)}$$

worin

$$\overline{e^{jb(t)}}$$

das Mittel dieser e-Funktion über eine Hauptgruppe ist.

Eine Einhüllende a(t), die verschieden von einer Konstanten ist, verursacht eine Wichtung der Amplitude der Übertragungsfunktion, und zwar für eine Realisierung der Struktur mit Fingern bzw. Digitstreifen, die ungewichtete Länge haben.

Eine Forderung ist, daß die zwangsläufig auftretenden Seitenbänder höchstens unwesentlich mit dem geforderten Hauptband überlappen. Dies erreicht man insbesonders durch Wahl der zusätzlichen Phasenwichtung b(t), so daß bei Hauptgruppen mit geradzahliger Anzahl von Subgruppen die Anzahl der in einer jeweiligen Hauptgruppe enthaltenen Oszillationen gleich der Hälfte der in dieser Hauptgruppe enthaltenen realen Subgruppen ist.

Insgesamt gilt somit die Vorschrift :

daß in einem solchen gewichteten Bereich — vergleichsweise zu dem Fall, daß dieser Bereich ungewichtet wäre — parallel zur Hauptachse Z der Wellenausbreitung eine oszillierende Verschiebung $\Delta z_i$ einer wesentlichen Anzahl von Subgruppen 81 mit 82, 83 mit 84, ...) vorliegt, wobei eine jede Subgruppe mindestens zwei aufeinanderfolgende reale Finger und gegebenenfalls weitere reale und/oder virtuelle Finger hat :

7

0 066 281

daß eine Anzahl n Hauptgruppen gebildet wird mit n gleich oder größer $T \cdot B$, worin $T \cdot B$ das Zeit-Bandbreite-Produkt ist, worin $T$ die vorgegebene Dauer der Filter-Impulsantwort und worin $B$ die vorgegebene Bandbreite der Übertragungsfunktion ist ;

daß eine jede Hauptgruppe wenigstens zwei reale Subgruppen 81, 82, 83, 84 ...) hat ;

daß das jeweilige Maß der Verschiebung $\Delta z_i$ dieser Finger der jeweiligen einzelnen Subgruppe für die Folge der Subgruppen dieses gewichteten Bereichs einer zusätzlichen oszillierenden Phasenmodulation $b(t)$ entspricht und diese Phasenmodulation $b(t)$ so oszilliert, daß innerhalb einer Hauptgruppe die Anzahl der Oszillationen eine ganze Zahl ist, die nicht größer als die Hälfte der Anzahl der in dieser Hauptgruppe enthaltenen realen Subgruppen ist, und wobei

$$\overline{e^{jb(t)}} \approx \frac{a(t)}{r(t)} \tag{III}$$

gilt, worin

$$\overline{e^{jb(t)}}$$

das Mittel dieser e-Funktion über eine Hauptgruppe 152 etwa gleich dem Verhältnis $a(t)/r(t)$ ist, worin $a(t)$ die vorgegebene Amplitudenmodulation der Filter-Impulsantwort ist, wobei gilt $r(t)$ ist gleich oder größer $a(t)$ für alle Werte von $t$, und daß das Maß der Verschiebung $\Delta z_i$ der Fingerkanten einer jeweiligen i-ten Subgruppe an ihrem Ort $z_i$ ihrer Mitte

$$\Delta z_i = \frac{\lambda i}{2 \pi} \cdot b(t)$$

worin

$$t_i = \frac{z_i}{v}$$

ist,

worin $z$ die Koordinate der Hauptrichtung der Wellenausbreitung mit der Geschwindigkeit $v$ und $\lambda_i$ die Wellenlänge am Ort der i-ten Subgruppe ist.

Für die Herstellung einer nach dem Beispiel der Fig. 5 gewichteten Fingerstruktur für das Filter war vorgesehen, zwei zusätzliche Belichtungsvorgänge durchzuführen, nämlich zusätzlich zur Belichtung der in Fig. 1 mit 2 bezeichneten Fingergruppen der noch nicht gewichteten Fingerstruktur. Mit der Fingerwichtung nach der oben beschriebenen Weiterbildung ist der große Vorteil verbunden, daß diese Zusatzbelichtungen zur Realisierung der Fingerwichtung eingespart werden können. Es müssen bei der Belichtung der einzelnen (ungewichteten) Fingergruppen lediglich die zusätzlichen Verschiebungen $z_i$ berücksichtigt werden, nämlich dahingehend, daß die in Fig. 1 angegebenen Abstände $A_1$, $A_2$, $A_3$ ... verändert werden, nämlich $A_1$ wird geändert in $B_1$ ; $A_3$ wird geändert in $B_3$. Daraus ergibt sich zwangsläufig für den bisherigen Fingergruppenabstand $A_2$ ein neuer Abstandswert $A_2 - \Delta z_1 + \Delta z_2$, d. h. der bisherige Abstand $A_2$ ändert sich um die Verschiebungen $\Delta z_i$ der Finger(sub)gruppen, zu denen dieser Abstand $A_2$ gehört.

Zu diesem technologischen Vorteil kommt noch ein physikalischer Vorteil hinzu. Weil nämlich bei einem Filter nach dieser Weiterbildung alle Finger unverkürzt sein können (d. h. keine Überlappungswichtung vorgesehen sein muß), entfällt bei einem Filter nach dieser Weiterbildung der Nachteil, daß bei starker Wichtung, d. h. bei nur geringer Fingerüberlappung, auftretende störende Beugungseffekte hier nicht auftreten können.

**Patentansprüche**

1. Mit akustischen Wellen arbeitendes Pulskompressionsfilter nach Art einer dispersiven Verzögerungsleitung mit einer vorgegebenen Mittenfrequenz $f_0$, die in dem Filter eine entsprechende mittlere Wellenlänge $\lambda_0$ ergibt, — mit wenigstens einem Eingangs-/Ausgangswandler mit einer Anzahl Elektrodenfinger (3) oder mit einer Anzahl Reflektorfinger (73) eines « reflective array compressor », die sich auf bzw. in der Oberfläche eines Substrats (10) befinden, — wobei die Verteilung der Elektroden- bzw. Reflektorfinger (3, 73) entsprechend der vorgegebenen Übertragungsfunktion ist, die eine vorgegebene Bandbreite B hat und deren Fourier-Transformierte (Pulsantwort) eine vorgegebene Zeitdauer T hat, — wobei die vorgesehenen Elektroden- bzw. Reflektorfinger (3, 73) in eine Anzahl N Fingergruppen (2, 72) aufgeteilt sind, — gekennzeichnet dadurch, daß diese Fingergruppen (2, 72) bezüglich der Fingeranzahl n

8

**0 066 281**

und des Fingerabstandsmusters ($a_1$, $a_2$, $a_3$, ...) untereinander identisch sind, — wobei eine jede Fingergruppe (2, 72) in Ausbreitungsrichtung (v, v') der akustischen Welle im Filter eine Länge (1) wenigstens gleich der mittleren Wellenlänge ($\lambda_o$) hat, — wobei die Mittenabstände ($A_i$) benachbarter Fingergruppen (2, 72) voneinander entsprechend der vorgegebenen Übertragungsfunktion entsprechend verschieden groß bemessen sind, und wobei die Beziehung gilt, daß die Anzahl N der Fingergruppen (2, 72) größer als das Bandbreite/Zeitdauer-Produkt (T · B) ist.

2. Pulskompressionsfilter nach Anspruch 1, gekennzeichnet dadurch, daß innerhalb der einzelnen Fingergruppe (2, 72) die Abstände ($a_i$) der Finger (3, 73) voneinander äquidistant sind.

3. Pulskompressionsfilter nach Anspruch 1 oder 2, gekennzeichnet dadurch, daß Elektrodenfinger (3') als « split finger »-Anordnungen (Fig. 4), bestehend aus Elektrodenstreifen (3″, 3‴ ...) ausgebildet sind.

4. Pulskompressionsfilter nach Anspruch 1, 2 oder 3, gekennzeichnet dadurch, daß in den einzelnen Fingergruppen (2, 72) die Finger (23) gewichtet sind (Fig. 5).

5. Pulskompressionsfilter nach Anspruch 4, gekennzeichnet dadurch, daß innerhalb der einzelnen Fingergruppen (61, 62, 63 ; 72) die Wichtung der Finger (23) einheitlich ist, so daß einzelne Fingergruppen (61, 62, 63) bezüglich der Fingerwichtung nichtidentische Anordnungen sind (Fig. 6).

6. Pulskompressionsfilter nach einem der Ansprüche 1 bis 5, gekennzeichnet dadurch, daß die Länge (1) einer einzelnen Fingergruppe (2 ; 61, 62, 63) um ein Mehrfaches größer als $n \cdot \lambda_o/2$ ist.

7. Pulskompressionsfilter nach einem der Ansprüche 1 bis 6, gekennzeichnet dadurch, daß für eine der vorgegebenen Übertragungsfunktion entsprechende Wichtung des Filters durch zusätzliche Fingerverschiebung wenigstens zwei benachbarte Fingergruppen mit je wenigstens zwei realen Fingern (3) als reale Subgruppen (81, 82 ; 83, 84, ...) zu einer Hauptgruppe zusammengefaßt sind, daß für die Finger (3) einer jeden Subgruppe (81 ... 84) eine dieser Fingerwichtung entsprechend bemessene Verschiebung $\Delta z_i$ gegenüber dem Ort dieser Finger (3) im ungewichteten Falle (Fig. 1) vorgesehen ist ; daß für jede Hauptgruppe die Summe der Verschiebungen $\Delta z_i$ der zu ihr gehörenden Subgruppen im wesentlichen gleich Null ist ; daß eine Anzahl n Hauptgruppen gebildet wird, mit n gleich oder größer T · B, worin T · B das Zeit-Bandbreite-Produkt ist, worin T die vorgegebene Dauer des Filter-Impulsantwort und worin B die vorgegebene Bandbreite der Übertragungsfunktion ist ; daß eine jede Hauptgruppe wenigstens zwei reale Subgruppen (53, 54 ; 57, 58, 59) hat ; daß das jeweilige Maß der Verschiebung $\Delta z_i$ der Finger der jeweiligen einzelnen Subgruppe für die Folge der Subgruppen dieses gewichteten Bereichs einer zusätzlichen oszillierenden Phasenmodulation b(t) entspricht und diese Phasenmodulation b(t) so oszilliert, daß innerhalb einer Hauptgruppe die Anzahl der Oszillationen eine ganze Zahl ist, die nicht größer als die Hälfte der Anzahl der in dieser Hauptgruppe enthaltenen realen Subgruppen ist, und wobei

$$\overline{e^{jb(t)}} \approx \frac{a(t)}{r(t)}$$

gilt, worin

$$\overline{e^{jb(t)}}$$

das Mittel dieser e-Funktion über eine Hauptgruppe (152) gleich dem Verhältnis a(t)/r(t) ist, worin a(t) die vorgegebene Amplitudenmodulation der Filter-Impulsantwort ist, wobei gilt r(t) ist gleich oder größer a(t) für alle Werte von T ; und daß das Maß der Verschiebung $\Delta z_i$ der Fingerkanten einer jeweiligen i-ten Subgruppe an ihrem Ort $z_i$ ihrer Mitte

$$\Delta z_i = \frac{\lambda i}{2 \pi} \cdot b(t)$$

worin

$$t_i = \frac{z_i}{v}$$

ist

worin z die Koordinate der Hauptrichtung der Wellenausbreitung mit der Geschwindigkeit v und $\lambda_i$ die Wellenlänge am Ort der i-ten Subgruppe ist.

**Claims**

1. A pulse compression filter operating with acoustic waves in the manner of a dispersive delay line

9

with a predetermined mean frequency $f_0$ which produces a corresponding mean wavelength $\lambda_0$ in the filter — with at least one input/output transducer having a number of electrode fingers (3) or having a number of reflector fingers (73) of a reflective array compressor arranged on or in the surface of a substrate (10) — where the distribution of the electrode fingers or reflector fingers (3, 73), as the case may be, corresponds to the predetermined transformation function which has a predetermined band-width B and whose Fourier transform (pulse response) has a predetermined time-period T — where the electrode fingers or reflector fingers (3, 73), as the case may be, are divided into a number N of finger groups (2, 72) — characterised in that these finger groups (2, 72) are mutually identical in respect of the number of fingers n and the finger spacing pattern ($a_1$, $a_2$, $a_3$ ...) — each finger group (2, 72), has a length (1) in the direction of propagation (v, v') of the acoustic wave in the filter, at least equal to the mean wavelength ($\lambda_0$) — the mean intervals ($A_i$) between adjacent finger groups (2, 72) differ in accordance with the predetermined transformation function — and the number N of the finger groups (2, 72) is greater than the band-width/time-period product ($T \cdot B$).

2. A pulse compression filter as claimed in Claim 1, characterised in that within the individual finger groups (2, 72) the fingers (3, 73) are equidistantly spaced by an interval ($a_i$).

3. A pulse compression filter as claimed in Claim 1 or 2, characterised in that the electrode fingers (3') each form a splitfinger arrangement (Fig. 4) consisting of electrode strips (3″, 3‴ ...).

4. A pulse compression filter as claimed in Claim 1, 2 or 3, characterised in that the fingers (23) are weighted in the individual finger groups (2, 72) (Fig. 5).

5. A pulse compression filter as claimed in Claim 4, characterised in that the weighting of the fingers (23) within the individual finger groups (61, 62, 63 ; 72) is uniform but the finger weighting is not identical for all finger groups (61, 62, 63) (Fig. 6).

6. A pulse compression filter as claimed in one of the Claims 1 to 5, characterised in that the length (1) of an individual finger group (2 ; 61, 62, 63) is a multiple greater than $n \cdot \lambda_0/2$.

7. A pulse compression filter as claimed in one of the Claims 1 to 6, characterised in that in order to weight the filter in accordance with the predetermined transformation function by means of additional finger displacement at least two adjacent finger groups, each comprising at least two real fingers (3) as real sub-groups (81, 82 ; 83, 84 ...) are combined to form a main group, the fingers (3) of each sub-group (81 ... 84) are subjected to a displacement $\Delta z_i$, corresponding to this finger weighting, in relation to the location of these fingers (3) when they are unweighted (Fig. 1) ; that for each main group the sum of the displacements $\Delta z_i$ of the sub-groups assigned thereto is fundamentally equal to zero ; that a number n of main groups is formed, where n is equal to or greater than $T \cdot B$., where $T \cdot B$. is the band-width/time-period product, where T is the given duration of the filter pulse response and where B is the predetermined band width of the transformation function ; that each main group comprises at least two real sub-groups (53, 54 ; 57, 58, 59) ; that the degree of the displacement $\Delta z_i$ of the fingers of the individual sub-group for the sequence of sub-groups of this weighted zone corresponds to an additional oscillating phase modulation b(t) and this phase modulation b(t) oscillates in such manner that within a main group the number of oscillations in a whole number which is no greater than half the number of real sub-groups contained in this main group and where

$$\overline{e^{jb(t)}} \approx \frac{a(t)}{r(t)}$$

where

$$\overline{e^{jb(t)}}$$

is the mean of this e-function over a main group (152) equal to the ratio a(t)/r(t), where a(t) is the given amplitude modulation of the filter pulse response, and where r(t) is equal to or greater than a(t) for all values of T ; and that the degree of the displacement $\Delta z_i$ of the finger edges of each i-th sub-group with respect to the location $z_i$ of its centre is

$$\Delta z_i = \frac{\lambda i}{2\pi} \cdot b(t)$$

wherein

$$t_i = \frac{z_i}{v}$$

where z is the coordinate of the main direction of the wave propagation at the speed v and $\lambda_i$ is the wavelength at the location of the i-th sub-group.

10

# 0 066 281

## Revendications

1. Filtre à compression d'impulsions opérant avec une onde acoustique et réalisé à la manière d'une ligne à retard dispersive possédant une fréquence centrale prédéterminée $f_o$, qui fournit dans le filtre une longueur d'onde moyenne correspondante $\lambda_o$, — comportant au moins un transducteur d'entrée/sortie pourvu d'un nombre de doigts formant électrodes (3) ou un nombre de doigts formant réflecteurs (73) d'un « reflective array compressor », qui sont situés sur ou dans la surface·d'un substrat (10), — la répartition des doigts formant électrodes ou des doigts formant réflecteurs (3, 73) correspondant à la fonction de transfert prédéterminée, qui possède une largeur de bande B prédéterminée et dont la transformée de Fourier (réponse impulsionnelle) possède une durée T prédéterminée, — les doigts formant électrodes ou les doigts formant réflecteurs (3, 73) prévus étant répartis en un nombre de N groupes de doigts (2, 72), — caractérisé par le fait que ces groupes de doigts (2, 72) sont identiques entre eux en ce qui concerne le nombre n des doigts et le modèle des distances entre doigts ($a_1$, $a_2$, $a_3$, ...), chaque groupe de doigts (2, 72) possède suivant la direction de propagation (v, v') de l'onde acoustique dans le filtre, une longueur (1) au moins égale à la longueur d'onde moyenne ($\lambda_o$), — les distances ($A_i$) entre les centres de groupes de doigts (2, 72) voisins possédant des dimensions différentes conformément à la fonction de transfert prédéterminée, avec la relation selon laquelle le nombre N des groupes de doigts (2, 72) est supérieur au produire (T·B) de la largeur de bande par la durée.

2. Filtre à compression d'impulsions suivant la revendication 1, caractérisé par le fait qu'à l'intérieur des différents groupes de doigts (2, 72), les distances ($a_i$) entre les doigts (3, 73) sont égales.

3. Filtre à compression d'impulsions suivant la revendication 1 ou 2, caractérisé par le fait que les doigts formant électrodes (3') sont réalisés sous la forme de dispositifs « split finger » (figure 4), constitués par des bandes d'électrodes (3″, 3‴ ...).

4. Filtre à compression d'impulsions suivant la revendication 1, 2 ou 3, caractérisé par le fait que dans les différents groupes de doigts (2, 72), les doigts (23) sont pondérés (figure 5).

5. Filtre à compression d'impulsions suivant la revendication 4, caractérisé par le fait qu'à l'intérieur des différents groupes de doigts (61, 62, 63 ; 72), la pondération des doigts (23) est uniforme de sorte que différents groupes de doigts (61, 62, 63) sont des dispositifs non identiques en ce qui concerne la pondération des doigts (figure 6).

6. Filtre à compression d'impulsions suivant l'une des revendications 1 à 5, caractérisé par le fait que la longueur (1) de chaque groupe de doigts (2 ; 61, 62, 63) est égale à un multiple de $n \cdot \lambda_o/2$.

7. Filtre à compression d'impulsions suivant l'une des revendications 1 à 6, caractérisé par le fait que pour une pondération du filtre, correspondant à la fonction de transfert prédéterminée, au moyen d'un décalage supplémentaire des doigts, au moins deux groupes voisins de doigts comportant chacun au moins deux doigts réels (3) sont réunis, en tant que sous-groupes réels (81, 82 ; 83, 84 ...), pour former un groupe principal, qu'il est prévu pour les doigts (3) de chaque sous-groupe (81 ... 84) un décalage ($\Delta z_i$) dimensionné conformément à cette pondération des doigts, par rapport à l'emplacement de ces doigts (3) lorsqu'ils ne sont pas pondérés (figure 1) ; que pour chaque groupe principal, la somme des décalages ($\Delta z_i$) des sous-groupes, qui en font partie, est essentiellement nulle ; qu'un nombre n de groupes principaux est formé, n étant égal ou supérieur à T·B, T·B représentant le produit de la durée par la largeur de bande, T la durée prédéterminée de la réponse impulsionnelle du filtre et B la largeur de bande prédéterminée de la fonction de transfert ; que chaque groupe principal comporte au moins deux sous-groupes réels (53, 54 ; 57, 58, 59) ; que la valeur respective du décalage $\Delta z_i$ des doigts de chaque sous-groupe individuel pour la succession des sous-groupes de cette zone pondérée correspond à une modulation de phase oscillatoire supplémentaire b(t) et cette modulation de phase b(t) oscille de telle sorte qu'à l'intérieur d'un groupe principal, le nombre des oscillations est un nombre entier qui n'est pas supérieur à la moitié du nombre des sous-groupes réels contenus dans ce groupe principal, avec

$$\overline{e^{jb(t)}} \approx \frac{a(t)}{r(t)}$$

dans laquelle

$$\overline{e^{jb(t)}}$$

à savoir la moyenne de cette fonction exponentielle pour un groupe principal (152), est égale au rapport a(t)/r(t), a(t) représentant la modulation d'amplitude prédéterminée de la réponse impulsionnelle du filtre et r(t) étant égal ou supérieur à a(t) pour toutes les valeurs de T ; et que la valeur du décalage $\Delta z_i$ des bords des doigts du i-ème sous-groupe à l'emplacement $z_i$ de son centre est

$$\Delta z_i = \frac{\lambda i}{2\pi} \cdot b(t)$$

11

avec

$$t_i = \frac{z_i}{v}$$

z représentant la coordonnée de la direction principale de la propagation de l'onde à la vitésse v et $\lambda_i$ étant la longueur d'onde à l'emplacement du i-ème sous-groupe.

## FIG 1

## FIG 2

# FIG 3

# FIG 4

# FIG 5

## FIG 6

A1 — A2 — A3 —

23

61    62    63    6

5

## FIG 7 .

A₁ — A₂ — A₃ —

76

73

72    71

72'

77    70    10

## FIG 8